# EUROPEAN PATENT APPLICATION

(11) **EP 4 393 893 A1**
(43) Date of publication of application: **03.07.2024**
(21) Application number: 22861062.2
(22) Date of filing: 29.07.2022
(51) Int. Cl.: C03C 3/12, C03C 3/14, C03C 3/145, C03C 8/16, C03C 8/24, G04G 3/00, H01L 23/02, H01L 23/10, H01L 23/29, H01L 23/31, H03H 9/02

(54) **GLASS COMPOSITION AND SEALING MATERIAL**

(30) Priority: 26.08.2021 JP 2021138019; 28.01.2022 JP 2022011449; 25.03.2022 JP 2022049241
(71) Applicant: Nippon Electric Glass Co., Ltd., Otsu-shi, Shiga 520-8639 (JP)
(72) Inventor: SANO, Shoichi, Otsu-shi, Shiga 520-8639 (JP); HIROSE, Masayuki, Otsu-shi, Shiga 520-8639 (JP); KITAMURA, Yoshiro, Otsu-shi, Shiga 520-8639 (JP); SHIRAGAMI, Toru, Otsu-shi, Shiga 520-8639 (JP)
(74) Representative: Henkel & Partner mbB
(86) International application number: PCT/JP2022/029329
(87) International publication number: WO 2023/026771

(57) **Abstract**

Provided are a glass composition and a sealing material that can be sealed at low temperature while having good weather resistance. The glass composition of the present invention is characterized by containing, in mol%, TeO₂ 15-80%, MoO₃+Ag₂O 0.1-30%, V₂O₅ 5-40%, CuO 0.1-35%, Pb0 0-10%.

## Description

### TECHNICAL FIELD

The present invention relates to a glass composition and a sealing material capable of airtight sealing at a low temperature while having weather resistance.

### BACKGROUND ART

A sealing material is used for a semiconductor integrated circuit, a crystal oscillator, a metal member, a vacuum insulation glass, a flat display device, a glass terminal for an LED, and the like. The sealing material is required to have chemical durability and heat resistance, and thus a glass-based sealing material is used instead of a resin-based adhesive. The sealing material is further required to have properties such as mechanical strength, fluidity, and weather resistance. In particular, a sealing temperature is required to be reduced as much as possible for sealing an electronic component on which a heat-sensitive element is mounted. Specifically, the sealing material is required to be capable of sealing at a temperature of 400°C or lower. As a glass satisfying this property, lead borate-based glass containing a large amount of PbO, which has a great effect of decreasing a softening point, has been widely used (for example, see Patent Literature 1).

### CITATION LIST

### PATENT LITERATURE

Patent Literature 1: JPS63-315536A
Patent Literature 2: JP2019-202921A

### SUMMARY OF INVENTION

### TECHNICAL PROBLEM

To reduce an environmental load, lead borate-based glass is desirably replaced by lead-free glass containing no PbO, and various types of low-softening-point lead-free glass have been developed.

However, glass with a lower softening point generally tends to have lower weather resistance. Thus, it is not easy to implement both a low softening point and high weather resistance. A CuO-TeO₂-MoO₃-based glass described in Patent Literature 2 is promising alternative candidate for lead borate-based glass, and has good weather resistance, but cannot be said to have a sufficiently low softening point.

In view of the above, an object of the present invention is to provide a glass composition and a sealing material capable of sealing at a low temperature while having good weather resistance.

### SOLUTION TO PROBLEM

As a result of intensive studies, the present inventors have found that the above problems can be solved by using predetermined TeO₂-V₂O₅-based glass, and have proposed the present invention. That is, the glass composition according to the present invention contains, in mol%, 15% to 80% of TeO₂, 0.1% to 30% of MoO₃ + Ag₂O, 5% to 40% of V₂O₅, 0.1% to 35% of CuO, and 0% to 10% of PbO as glass composition. "A + B" indicates a total amount of a component A and a component B. For example, "MoOs + Ag₂O" refers to a total amount of MoOs and Ag₂O.

In addition, the glass composition according to the present invention preferably contains, in mol%, 0.3% to 25% of CuO, 1% to 30% of Li₂O + Na₂O + K₂O, and 1% to 30% of MgO + CaO + SrO + BaO + ZnO, and is substantially free of SeO₂. "Substantially free of SeO₂" means that a content of SeO₂ is less than 0.1 mol%.

In addition, in the glass composition according to the present invention, a content of ZnO is preferably 0 mol% to 25 mol%.

In addition, in the glass composition according to the present invention, a content of Nb₂O₅ is preferably 0 mol% to 10 mol%.

In addition, the glass composition according to the present invention preferably contains, in mol%, 0% to 10% of Fe₂O₃, 0% to 10% of Al₂O₃, 0% to 20% of B₂O₃, and 0% to 20% of WO₃ as glass composition.

A sealing material according to the present invention preferably contains 40 vol% to 100 vol% of a glass powder made of the above glass composition and 0 vol% to 60 vol% of a refractory filler powder.

In addition, in the sealing material according to the present invention, the refractory filler powder is preferably substantially spherical. Here, the "substantially spherical" is not limited only to a true sphere, and refers to a refractory filler powder in which a value obtained by dividing the shortest diameter passing through a center of gravity of the refractory filler powder by the longest diameter is 0.5 or more, and preferably 0.7 or more.

In addition, in the sealing material according to the present invention, the refractory filler powder is preferably entirely or partially Zr₂WO₄(PO₄)₂.

In addition, the sealing material according to the present invention is preferably used for a crystal oscillator package.

In addition, the sealing material according to the present invention is preferably used for vacuum insulation glass.

A sealing material paste according to the present invention preferably contains the above sealing material and a vehicle.

### ADVANTAGEOUS EFFECTS OF INVENTION

The present invention can provide a glass composition and a sealing material capable of sealing at a low temperature while having good weather resistance.

### BRIEF DESCRIPTION OF DRAWING

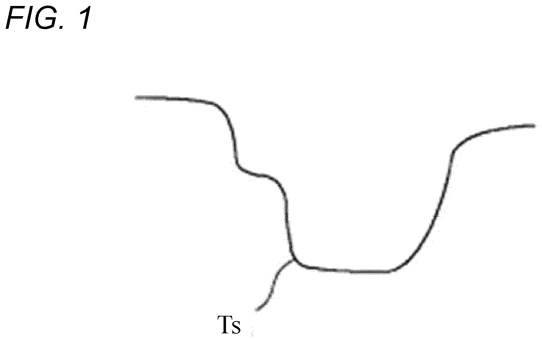

FIG. 1 is a schematic diagram showing a measurement curve obtained by a macro-type differential thermal analyzer.

### DESCRIPTION OF EMBODIMENTS

A glass composition according to the present invention contains, in mol%, 15% to 80% of TeO₂, 0.1% to 30% of MoO₃ + Ag₂O, 5% to 40% of V₂O₅, 0.1% to 35% of CuO, and 0% to 10% of PbO as glass composition. A reason for limiting a glass composition range as described above is shown below. In the description regarding a content of each component, "%" means "mol%" unless otherwise specified.

TeO₂ is a component that forms a glass network and that increases weather resistance. A content of TeO₂ is 15% to 80%, preferably 20% to 70%, and particularly preferably 25% to 65%. In a case where the content of TeO₂ is extremely small, the glass becomes thermally unstable, and the glass is prone to devitrification during melting or firing. On the other hand, in a case where the content of TeO₂ is extremely large, a viscosity (softening point or the like) of the glass becomes high, low-temperature sealing becomes difficult, and a thermal expansion coefficient tends to be extremely high.

MoO₃ and Ag₂O are components that form a glass network and that reduce the viscosity (softening point or the like) of the glass while maintaining the weather resistance of the glass. A content of MoO₃ + Ag₂O is 0.1% to 30%, preferably 1% to 29%, 3% to 28%, 5% to 28%, 7% to 27%, 10% to 25%, 12% to 22%, and particularly preferably 15% to 20%. In a case where the content of MoO₃ + Ag₂O is extremely small, vitrification becomes difficult, the viscosity (softening point or the like) of the glass increases, and low-temperature sealing becomes difficult. On the other hand, in a case where the content of MoO₃ + Ag₂O is extremely large, the glass becomes thermally unstable, the glass is prone to devitrification during melting or firing, and the thermal expansion coefficient tends to be extremely high.

A content of MoO₃ is preferably 0% to 30%, 0.1% to 29%, 1% to 29%, 5% to 28%, 7% to 27%, 10% to 25%, 12% to 22%, and particularly preferably 15% to 20%.

A content of Ag₂O is preferably 0% to 30%, 0.1% to 29%, 1% to 29%, 5% to 28%, 7% to 27%, 10% to 25%, 12% to 22%, and particularly preferably 15% to 20%.

V₂O₅ is a component that forms a glass network and that reduces the viscosity (softening point or the like) of the glass. In addition, V₂O₅ is also a component that lowers the thermal expansion coefficient. A content of V₂O₅ is 5% to 40%, preferably 7% to 35%, 8% to 30%, 10% to 25%, and particularly preferably 12% to 20%. In a case where the content of V₂O₅ is extremely small, vitrification becomes difficult, the viscosity (softening point or the like) of the glass increases, and low-temperature sealing becomes difficult. In addition, the thermal expansion coefficient tends to be extremely high. On the other hand, in a case where the content of V₂O₅ is extremely large, the glass becomes thermally unstable, and the glass is prone to devitrification during melting or firing.

CuO is a component that lowers the viscosity (softening point or the like) of the glass and that lowers the thermal expansion coefficient. In addition, CuO is a component that increases an adhesion strength between glass and a metal when the metal is sealed. Although a mechanism of increasing the adhesion strength is unknown at present, Cu atoms have high diffusivity and thus diffuse from the surface toward the inside of the metal, and this presumably facilitates integration of glass and metal. A type of the metal, which is an object to be sealed, is not particularly limited, but examples thereof include iron, iron alloys, nickel, nickel alloys, copper, copper alloys, aluminum, and aluminum alloys. A content of CuO is 0.1% to 35%, preferably 0.2% to 30%, 0.3% to 25%, 0.4% to 20%, 0.5% to 15%, 1% to 12%, and particularly preferably 3% to 11%. In a case where the content of CuO is extremely small, vitrification becomes difficult, the viscosity (softening point or the like) of the glass increases, and low-temperature sealing becomes difficult. In addition, the thermal expansion coefficient tends to be extremely high. In a case where the content of CuO is extremely large, the glass becomes thermally unstable, and the metal Cu is deposited from the glass surface in a sealing step, which may adversely affect the sealing strength and electrical properties. In addition, the glass is prone to devitrification during melting or firing.

PbO is a component that lowers the viscosity (softening point or the like) of the glass, but in consideration of the environmental aspect, a content of PbO is 0% to 10%, preferably 0% to 5%, 0% to 3%, 0% to 1%, and particularly preferably substantially free (less than 0.1%).

The following components may be introduced in addition to the above components.

Li₂O, Na₂O, and K₂O are components that lower the viscosity (softening point or the like) of the glass. A content of Li₂O + Na₂O + K₂O is preferably 0% to 30%, 1% to 30%, 5% to 25%, and particularly preferably 10% to 20%. In a case where the content of Li₂O + Na₂O + K₂O is extremely small, the viscosity (softening point or the like) of the glass may increase, and sealing at a low temperature may become difficult. In addition, vitrification may become difficult. On the other hand, in a case where the content of Li₂O + Na₂O + K₂O is extremely large, the glass becomes thermally unstable, and the glass is prone to devitrification during melting or firing. In addition, the weather resistance is likely to be deteriorated, and the thermal expansion coefficient tends to be extremely high.

Li₂O is a component that significantly reduces the viscosity (softening point or the like) of the glass as compared with Na₂O and K₂O. A content of Li₂O is preferably 0% to 30%, 1 to 20%, 3 to 15%, and particularly preferably 5% to 13%. In a case where the content of Li₂O is extremely small, the viscosity (softening point or the like) of the glass may increase, and sealing at a low temperature may become difficult. In addition, vitrification may become difficult. On the other hand, in a case where the content of Li₂O is extremely large, the glass becomes thermally unstable, and the glass is prone to devitrification during melting or firing. In addition, the weather resistance is likely to be deteriorated, and the thermal expansion coefficient tends to be extremely high.

K₂O is a component having a greater effect of reducing the viscosity (softening point or the like) of the glass as compared with Na₂O. A content of K₂O is preferably 0% to 30%, 1% to 20%, 3% to 15%, and particularly preferably 5% to 13%. In a case where the content of K₂O is extremely small, the viscosity (softening point or the like) of the glass may increase, and sealing at a low temperature may become difficult. In addition, vitrification may become difficult. On the other hand, in a case where the content of K₂O is extremely large, the glass becomes thermally unstable, and the glass is prone to devitrification during melting or firing. In addition, the weather resistance is likely to be deteriorated, and the thermal expansion coefficient tends to be extremely high.

Na₂O is a component that lowers the viscosity (softening point or the like) of the glass. A content of Na₂O is preferably 0% to 30%, 0.1% to 20%, 1% to 15%, and particularly preferably 3% to 13%. In a case where the content of Na₂O is extremely small, the viscosity (softening point or the like) of the glass may increase, and sealing at a low temperature may become difficult. In addition, vitrification may become difficult. On the other hand, in a case where the content of Na₂O is extremely large, the glass becomes thermally unstable, and the glass is prone to devitrification during melting or firing. In addition, the weather resistance is likely to be deteriorated, and the thermal expansion coefficient tends to be extremely high.

A molar ratio Li₂O/K₂O is preferably 0.3 to 5, 0.4 to 4, 0.5 to 3, 0.6 to 2, and particularly preferably 0.7 to 1.5 in order to lower the softening point by an alkali mixing effect. In a case where the molar ratio Li₂O/K₂O is out of the above range, the glass may become thermally unstable, and the glass may be prone to devitrification during melting or firing. The term "Li₂O/K₂O" refers to a value obtained by dividing the content of Li₂O by the content of K₂O.

A molar ratio Na₂O/K₂O is preferably 0.3 to 5, 0.4 to 4, 0.5 to 3, 0.6 to 2, and particularly preferably 0.7 to 1.5 in order to lower the softening point by an alkali mixing effect. In a case where the molar ratio Na₂O/K₂O is out of the above range, the glass may become thermally unstable, and the glass may be prone to devitrification during melting or firing. The term "Na₂O/K₂O" refers to a value obtained by dividing the content of Na₂O by the content of K₂O.

MgO, CaO, SrO, BaO, and ZnO are components that expand the vitrification range and that improve the weather resistance. MgO + CaO + SrO + BaO + ZnO is preferably 0% to 30%, 1% to 30%, 3% to 20%, and particularly preferably 5% to 15%. In a case where a content of MgO + CaO + SrO + BaO + ZnO is extremely small, the viscosity (softening point or the like) of the glass may increase, and sealing at a low temperature may become difficult. In addition, vitrification may become difficult. On the other hand, in a case where the content of MgO + CaO + SrO + BaO + ZnO is extremely large, the glass becomes thermally unstable, and the glass is prone to devitrification during melting or firing. In addition, the weather resistance is likely to be deteriorated, and the thermal expansion coefficient tends to be extremely high.

MgO is a component that expands the vitrification range and that improves the weather resistance. A content of MgO is preferably 0% to 25%, 0% to 20%, 0% to 10%, and particularly preferably 1% to 7%. In a case where the content of MgO is small, vitrification may become difficult. In addition, the viscosity (softening point or the like) of the glass may increase, and sealing at a low temperature may become difficult. On the other hand, in a case where the content of MgO is extremely large, the glass becomes thermally unstable, and the glass is prone to devitrification during melting or firing. In addition, the weather resistance is likely to be deteriorated, and the thermal expansion coefficient tends to be extremely high.

CaO is a component that expands the vitrification range and that improves the weather resistance. A content of CaO is preferably 0% to 25%, 0% to 20%, 0% to 10%, and particularly preferably 1% to 7%. In a case where the content of CaO is small, vitrification may become difficult. In addition, the viscosity (softening point or the like) of the glass may increase, and sealing at a low temperature may become difficult. On the other hand, in a case where the content of CaO is extremely large, the glass becomes thermally unstable, and the glass is prone to devitrification during melting or firing. In addition, the weather resistance is likely to be deteriorated, and the thermal expansion coefficient tends to be extremely high.

SrO is a component that expands the vitrification range and that improves the weather resistance. A content of SrO is preferably 0% to 25%, 0% to 20%, 0% to 10%, and particularly preferably 1% to 7%. In a case where the content of SrO is small, vitrification may become difficult. In addition, the viscosity (softening point or the like) of the glass may increase, and sealing at a low temperature may become difficult. On the other hand, in a case where the content of SrO is extremely large, the glass becomes thermally unstable, and the glass is prone to devitrification during melting or firing. In addition, the weather resistance is likely to be deteriorated, and the thermal expansion coefficient tends to be extremely high.

BaO is a component that expands the vitrification range and that improves the weather resistance. A content of BaO is preferably 0% to 25%, 0.1% to 20%, 0.5% to 10%, and particularly preferably 1% to 7%. In a case where the content of BaO is small, vitrification may become difficult. In addition, the viscosity (softening point or the like) of the glass may increase, and sealing at a low temperature may become difficult. On the other hand, in a case where the content of BaO is extremely large, the glass becomes thermally unstable, and the glass is prone to devitrification during melting or firing. In addition, the weather resistance is likely to be deteriorated, and the thermal expansion coefficient tends to be extremely high.

ZnO is a component that expands the vitrification range and that improves the weather resistance. A content of ZnO is preferably 0% to 25%, 0.1% to 22%, 1% to 20%, and particularly preferably 2% to 15%. In a case where the content of ZnO is extremely small, vitrification becomes difficult. In addition, the viscosity (softening point or the like) of the glass increases, and low-temperature sealing becomes difficult. On the other hand, in a case where the content of ZnO is extremely large, the glass becomes thermally unstable, and the glass is prone to devitrification during melting or firing. In addition, the weather resistance is likely to be deteriorated, and the thermal expansion coefficient tends to be extremely high.

AgI is a component that lowers the viscosity (softening point or the like) of the glass. A content of AgI is preferably 0% to 3%, 0% to 2%, and particularly preferably 0% to 1%. In a case where the content of AgI is extremely large, the thermal expansion coefficient tends to be extremely high.

SeO₂ is a component that lowers the viscosity (softening point or the like) of the glass, but in consideration of the environmental aspect, a content of SeO₂ is preferably 0% to 10%, 0% to 5%, 0% to 3%, 0 to 1%, and particularly preferably substantially free (less than 0.1%).

Fe₂O₃ is a component that enhances reactivity with the object to be sealed. A content of Fe₂O₃ is preferably 0% to 10%, 0% to 8%, 0.1% to 10%, and particularly preferably 1% to 7%. In a case where the content of Fe₂O₃ is extremely large, vitrification becomes difficult, the viscosity (softening point or the like) of the glass increases, and low-temperature sealing becomes difficult.

Al₂O₃ is a component that improves the weather resistance. A content of Al₂O₃ is preferably 0% to 10%, 0% to 8%, 0% to 6%, and particularly preferably 0.1% to 5%. In a case where the content of Al₂O₃ is extremely large, the viscosity (softening point or the like) of the glass increases, and low-temperature sealing becomes difficult.

B₂O₃ is a component that forms a glass network. A content of B₂O₃ is 0% to 20%, preferably 0% to 10%, and particularly preferably 0.1% to 5%. In a case where the content of B₂O₃ is extremely large, the viscosity (softening point or the like) of the glass becomes high, the low-temperature sealing becomes difficult, and the glass is prone to phase separation. In addition, vitrification becomes difficult.

WO₃ is a component that decreases the thermal expansion coefficient. A content of WO₃ is preferably 0% to 20%, 0% to 10%, 0% to 5%, and particularly preferably 0.1% to 3%. In a case where the content of WO₃ is extremely large, the glass becomes thermally unstable, the glass is prone to devitrification during melting or firing, the viscosity (softening point or the like) of the glass increases, and low-temperature sealing becomes difficult.

P₂O₅ is a component that forms a glass network and that thermally stabilizes the glass. A content of P₂O₅ is preferably 0% to 10%, 0% to 5%, 0% to 2%, and particularly preferably 0% to 1%. In a case where the content of P₂O₅ is extremely large, the viscosity (softening point or the like) of the glass becomes high, the low-temperature sealing becomes difficult, and the weather resistance is likely to be deteriorated.

Nb₂O₅ is a component that thermally stabilizes the glass and that increases the weather resistance. A content of Nb₂O₅ is preferably 0% to 10%, 0% to 5%, 0.1% to 4%, 0.5% to 3.5%, 1% to 3%, and particularly preferably 1% to 2.5%. In a case where the content of Nb₂O₅ is extremely small, the glass becomes thermally unstable, and the glass is prone to devitrification during melting or firing. On the other hand, in a case where the content of Nb₂O₅ is extremely large, the viscosity (softening point or the like) of the glass increases, and low-temperature sealing tends to be difficult.

La₂O₃ is a component that thermally stabilizes the glass to suppress devitrification of the glass. A content of La₂O₃ is preferably 0% to 10%, 0% to 5%, 0% to 2%, and particularly preferably 0.1% to 1%. In a case where the content of La₂O₃ is extremely large, the viscosity (softening point or the like) of the glass increases, and low-temperature sealing tends to be difficult.

Ga₂O₃ is a component that thermally stabilizes the glass and that increases the weather resistance, but is very expensive, and therefore, a content thereof is preferably less than 0.01%.

TiO₂, GeO₂, CeO₂, and Sb₂O₃ are components that thermally stabilize the glass to suppress devitrification, and each of these components can be added up to less than 5%. In a case where the content of each component is extremely large, the glass becomes thermally unstable, and the glass is prone to devitrification during melting or firing.

The sealing material according to the present invention contains a glass powder made of the above-described glass composition. The sealing material according to the present invention may contain a refractory filler powder in order to improve the mechanical strength or to adjust the thermal expansion coefficient. A mixing ratio is preferably 40 vol% to 100 vol% of the glass powder and 0 vol% to 60 vol% of the refractory filler powder, 50 vol% to 99 vol% of the glass powder and 1 vol% to 50 vol% of the refractory filler powder, 60 vol% to 95 vol% of the glass powder and 5 vol% to 40 vol% of the refractory filler powder, and particularly preferably 70 vol% to 90 vol% of the glass powder and 10 vol% to 30 vol% of the refractory filler powder. In a case where the content of the refractory filler powder is extremely large, a ratio of the glass powder becomes relatively small, and thus it becomes difficult to ensure desired fluidity.

The refractory filler powder preferably contains Zr₂WO₄(PO₄)₂. Zr₂WO₄(PO₄)₂ has properties of hardly reacting with the glass powder according to the present invention and further significantly reducing the thermal expansion coefficient of the sealing material.

In addition, for the sealing material according to the present invention, a refractory filler powder other than Zr₂WO₄(PO₄)₂ can also be used as the refractory filler powder. Examples of such another refractory filler powder include powders made of NbZr(PO₄)₃, Zr₂MoO₄(PO₄)₂, Hf₂WO₄(PO₄)₂, Hf₂MoO₄(PO₄)₂, zirconium phosphate, zircon, zirconia, tin oxide, aluminum titanate, quartz, β-spodumene, mullite, titania, quartz glass, β-eucryptite, β-quartz, willemite, cordierite, or Sr_{0.5}Zr₂(PO₄)₃. Such a powder can be used individually, or two or more of such powders can be mixed and used.

The refractory filler powder is preferably substantially spherical. Such a refractory filler powder is less likely to inhibit the fluidity of the glass powder when the glass powder is softened, resulting in the improvement of the fluidity of the sealing material. In addition, this makes it easier to obtain a smooth glaze layer. Further, even when a portion of the refractory filler powder is exposed to a surface of the glaze layer, the stress of this portion may be dispersed because of the substantially spherical shape of the refractory filler powder. Accordingly, it is less likely to apply improper stress to an object to be sealed and to easily ensure airtightness even when the object to be sealed is brought into contact with the glaze layer upon sealing.

An average particle size D₅₀ of the refractory filler powder is preferably 0.2 µm to 20 µm, and particularly preferably 2 µm to 15 µm. In a case where the average particle size D₅₀ is extremely large, the sealing layer is prone to be thick. On the other hand, in a case where the average particle size D₅₀ is extremely small, the refractory filler powder is extracted into the glass during sealing, and the glass is prone to devitrification.

In the sealing material according to the present invention, the softening point is preferably 360°C or lower, 350°C or lower, 340°C or lower, 330°C or lower, 320°C or lower, 310°C or lower, 300°C or lower, 295°C or lower, and particularly preferably 290°C or lower. In a case where the softening point is extremely high, the viscosity of the glass may increase, thus the sealing temperature may increase, and an element may be deteriorated by heat during sealing. A lower limit of the softening point is not particularly limited, but is realistically 180°C or higher. Here, the "softening point" refers to a value measured by a macro-type differential thermal analyzer using a sealing material having an average particle size D₅₀ of 0.5 µm to 20 µm as a measurement sample. As measurement conditions, measurement is started from room temperature, and a heating rate is 10°C/min. The softening point measured by a macro-type differential thermal analyzer refers to the temperature (Ts) at a fourth inflection point in a measurement curve shown in FIG. 1.

In the sealing material according to the present invention, the thermal expansion coefficient in a temperature range of 30°C to 150°C is preferably 20 × 10⁻⁷/°C to 200 × 10⁻⁷/°C, more preferably 30 × 10⁻⁷/°C to 160 × 10⁻⁷/°C, still more preferably 40 × 10⁻⁷/°C to 140 × 10⁻⁷/°C, and particularly preferably 50 × 10⁻⁷/°C to 120 × 10⁻⁷/°C. In a case where the thermal expansion coefficient is out of the above range, a sealing portion is prone to breaking at the time of sealing or after sealing due to a difference in thermal expansion from a material to be sealed.

Next, an example of a manufacturing method and a use method of the glass powder and the sealing material according to the present invention will be described.

First, a raw material powder prepared to have desired glass composition is melted at 700°C to 1,000°C for 1 hour to 2 hours until homogeneous glass is obtained. Next, the obtained molten glass is formed into a film shape or the like, and then ground and classified to produce a glass powder. The average particle size D₅₀ of the glass powder is preferably about 1 µm to 20 µm. As necessary, various types of the refractory filler powder is added to and mixed with the glass powder to form a sealing material.

Next, a vehicle is added to and kneaded with the sealing material to prepare a sealing material paste. The vehicle is mainly made of an organic solvent and a resin, and the resin is added to adjust the viscosity of the paste. In addition, a surfactant, a thickener, or the like can also be added as necessary.

The organic solvent preferably has a low boiling point (e.g., a boiling point of 300°C or lower), leaves little residue after firing, and does not change the glass in quality. A content thereof is preferably 10 mass% to 40 mass%. As the organic solvent, propylene carbonate, toluene, N,N'-dimethylformamide (DMF), 1,3-dimethyl-2-imidazolidinone (DMI), dimethyl carbonate, butyl carbitol acetate (BCA), isoamyl acetate, dimethyl sulfoxide, acetone, methyl ethyl ketone, or the like is preferably used. In addition, a higher alcohol is more preferably used as the organic solvent. The higher alcohol itself has viscosity and thus can be formed into a paste without adding any resin to the vehicle. In addition, pentanediol and derivatives thereof, specifically, diethylpentanediol (C₉H₂₀O₂), have excellent viscosity and thus can be used as the solvent.

The resin preferably has a low decomposition temperature, leaves little residue after firing, and hardly change the glass in quality. A content thereof is preferably 0.1 mass% to 20 mass%. As the resin, nitrocellulose, polyethylene glycol derivatives, polyethylene carbonate, acrylic esters (acrylic resins), or the like is preferably used.

The sealing material paste is then applied to a sealed portion of an object to be sealed made of metal, ceramic, or glass, using a coating machine such as a dispenser or a screen printer, dried, and subjected to a glaze treatment at 280°C to 320°C. Thereafter, another object to be sealed is brought into contact and subjected to a heat treatment at 300°C to 400°C to allow the glass powder to soften and flow, and both are sealed.

The glass powder according to the present invention can be used for the purpose of coating or filling, in addition to sealing applications. In addition, the glass powder can also be used in a form other than the paste, specifically such as a powder, a green sheet, or a tablet (form prepared by sintering the powder material into a given shape).

### EXAMPLES

The present invention will be described in detail based on examples. Tables 1 to 3 show examples of the present invention (Sample Nos. 1 to 9 and 13 to 27) and comparative examples (Sample Nos. 10 to 12).

**[Table 1]**

| | | Example | | | | | | | | | Comparative example | | |
|---|---|---|---|---|---|---|---|---|---|---|---|---|---|
| | | No.1 | No.2 | No.3 | No.4 | No.5 | No.6 | No.7 | No.8 | No.9 | No.10 | No. 11 | No.12 |
| Glass composition (mol%) | TeO₂ | 46 | 47 | 46 | 44 | 45 | 47 | 44 | 45 | 45 | 53 | 50 | 33 |
| | MoO₃ | 15 | 12 | 12 | 5 | 9 | 12 | 5 | 8 | 8 | 26 | 29 | 7 |
| | Ag₂O | | | | | | | | | | | | |
| | V₂O₅ | 15 | 17 | 15 | 15 | 12 | 17 | 18 | 17 | 15 | 3 | 3 | 42 |
| | CuO | 10 | 10 | 6 | 10 | 12 | 5 | 10 | 10 | 9 | | 2 | |
| | Li₂O | 7 | 7 | | 8 | 8 | 7 | | 8 | 9 | 9 | 8 | 9 |
| | Na₂O | | | 7 | | 8 | | 7 | | 9 | | | |
| | K₂O | 7 | 7 | 7 | 8 | | 7 | 7 | 8 | | 9 | 8 | 9 |
| | MgO | | | | | 2 | | | | | | | |
| | CaO | | | | | 2 | | | | | | | |
| | SrO | | | | | | 3 | | | | | | |
| | BaO | | | | | | 2 | | | 3 | | | |
| | ZnO | | | 5 | 10 | | | 8 | | | | | |
| | Fe₂O₃ | | | 2 | | 2 | | | | 2 | | | |
| | Al₂O₃ | | | | | | | 1 | | | | | |
| | B₂O₃ | | | | | | | | 4 | | | | |
| | Total | 100 | 100 | 100 | 100 | 100 | 100 | 100 | 100 | 100 | 100 | 100 | 100 |
| | MoO₃+Ag₂O | 15 | 12 | 12 | 5 | 9 | 12 | 5 | 8 | 8 | 26 | 29 | 7 |
| | Li₂O+Na₂O+K₂O | 14 | 14 | 14 | 16 | 16 | 14 | 14 | 16 | 18 | 18 | 16 | 18 |
| | MgO+CaO+SrO+ BaO+ZnO | 0 | 0 | 5 | 10 | 4 | 5 | 8 | 0 | 3 | 0 | 0 | 0 |
| Refractory filler powder | | ZWP | ZWP | ZWP | ZWP | ZWP | ZWP | ZWP | ZWP | ZWP | ZWP | ZWP | ZWP |
| (vol%) | | 40 | 40 | 40 | 40 | 40 | 40 | 35 | 40 | 40 | 40 | 40 | 35 |
| Glass transition point (°C) | | 270 | 255 | 271 | 263 | 265 | 261 | 273 | 266 | 262 | 297 | 292 | 243 |
| Thermal expansion coefficient (x 10⁻⁷/°C) | | 75 | 71 | 78 | 75 | 80 | 73 | 78 | 80 | 72 | 73 | 72 | 69 |
| Softening point (°C) | | 317 | 309 | 320 | 318 | 314 | 319 | 318 | 320 | 311 | 347 | 342 | 293 |
| Fluidity | | Good | Good | Good | Good | Good | Good | Good | Good | Good | Poor | Poor | Devitrify at 350°C |
| Weather resistance | | Good | Good | Good | Good | Good | Good | Good | Good | Good | Good | Good | |

**[Table 2]**

| | | Example | | | |
|---|---|---|---|---|---|
| | | No.13 | No.14 | No.15 | No.16 |
| Glass composition (mol%) | TeO₂ | 24 | 39 | 30 | 40 |
| | MoO₃ | | | | |
| | Ag₂O | 13 | 20 | 19 | 15 |
| | V₂O₅ | 31 | 21 | 30 | 18 |
| | CuO | 17 | 5 | 7 | 13 |
| | Li₂O | 4.5 | 6 | 5 | 4.5 |
| | Na₂O | | | | |
| | K₂O | 3 | 1 | 3 | 3 |
| | MgO | | | | |
| | CaO | | | | |
| | SrO | | | | |
| | BaO | 5 | 5 | 4 | 4 |
| | ZnO | | | | |
| | Fe₂O₃ | 0.5 | 1 | 0.5 | 0.5 |
| | Al₂O₃ | 0.5 | 0.5 | 0.5 | 1 |
| | B₂O₃ | | | | |
| | WO₃ | 0.5 | 1 | 0.5 | 0.5 |
| | La₂O₃ | 1 | 0.5 | 0.5 | 0.5 |
| | Total | 100 | 100 | 100 | 100 |
| | MoO₃+As₂O | 13 | 20 | 19 | 15 |
| | Li₂O+Na₂O+K₂O | 7.5 | 7 | 8 | 7.5 |
| | MgO+CaO+SrO+BaO+ZnO | 5 | 5 | 4 | 4 |
| Refractory filler powder | | ZWP | ZWP | ZWP | ZWP |
| (vol%) | | 40 | 40 | 40 | 40 |
| Glass transition point (°C) | | 211 | 199 | 197 | 205 |
| Thermal expansion coefficient (×10⁻⁷/°C) | | 81 | 84 | 82 | 80 |
| Softening point (°C) | | 307 | 292 | 286 | 282 |
| Fluidity | | Good | Good | Good | Good |
| Weather resistance | | Good | Good | Good | Good |

**[Table 3]**

| | | Example | | | | | | | | | | |
|---|---|---|---|---|---|---|---|---|---|---|---|---|
| | | No.17 | No.18 | No.19 | No.20 | No.21 | No.22 | No.23 | No.24 | No.25 | No.26 | No.27 |
| | TeO₂ | 30 | 30 | 33 | 28 | 28 | 30 | 31 | 30 | 40 | 40 | 30 |
| | MoO₃ | 2 | 2 | 1 | 1 | 1 | 1 | 1 | 1 | 1 | 1 | 1 |
| | Ag₂O | | | | | | | | | | | |
| | V₂O₅ | 18 | 18 | 17 | 17 | 17 | 18 | 17 | 19 | 15 | 15 | 19 |
| | CuO | 28 | 28 | 20 | 25 | 25 | 28 | 26 | 25 | 23 | 23 | 25 |
| | Li₂O | 9 | | 10 | 10 | 10 | 8 | 8 | 8 | 8.5 | 8.5 | 8 |
| | Na₂O | | 9 | | | | | | | | | |
| | K₂O | 9 | 9 | 10 | 10 | 10 | 8 | 8 | 8 | 8.5 | 8.5 | 8 |
| | MgO | | | | | 3 | | | | | | |
| | CaO | | | | 3 | | | | | | | |
| | SrO | | | 3 | | | 3 | 3 | 3 | | | 3 |
| Glass composition (mol%) | BaO | 2 | 2 | 3 | 3 | 3 | 3 | 3 | 3 | 2 | 2 | 3 |
| | ZnO | | | | | | | 2 | | | | |
| | Fe₂O₃ | | | | | | | | | | | 2 |
| | Al₂O₃ | | | | | | | | | 0.5 | | |
| | B₂O₃ | | | | | | | | | | 0.5 | |
| | WO₃ | | | | | | | | 2 | | | |
| | La₂O₃ | | | | | | | | | | | |
| | Nb₂O₅ | 2 | 2 | 3 | 3 | 3 | 1 | 1 | 1 | 1.5 | 1.5 | 1 |
| | Total | 100 | 100 | 100 | 100 | 100 | 100 | 100 | 100 | 100 | 100 | 100 |
| | MoO₃+Ag₂O | 2 | 2 | 1 | 1 | 1 | 1 | 1 | 1 | 1 | 1 | 1 |
| | Li₂O+Na₂O+K₂O | 18 | 18 | 20 | 20 | 20 | 16 | 16 | 16 | 17 | 17 | 16 |
| | MgO+CaO+SrO+ BaO+ZnO | 2 | 2 | 6 | 6 | 6 | 6 | 8 | 6 | 2 | 2 | 6 |
| Refractory filler powder | | ZWP | ZWP | ZWP | ZWP | ZWP | ZWP | ZWP | ZWP | ZWP | ZWP | ZWP |
| (vol%) | | 40 | 40 | 40 | 40 | 40 | 40 | 40 | 40 | 40 | 40 | 40 |
| Glass transition point (°C) | | 260 | 258 | 269 | 265 | 263 | 259 | 261 | 265 | 271 | 264 | 266 |
| Thermal expansion coefficient (×10⁻⁷/°C) | | 74 | 77 | 78 | 73 | 75 | 72 | 75 | 69 | 65 | 67 | 72 |
| Softening point (°C) | | 335 | 330 | 330 | 333 | 337 | 328 | 331 | 338 | 349 | 347 | 340 |
| Fluidity | | Good | Good | Good | Good | Good | Good | Good | Good | Good | Good | Good |
| Weather resistance | | Good | Good | Good | Good | Good | Good | Good | Good | Good | Good | Good |

First, a raw material powder prepared to have the glass composition shown in the tables was placed in a platinum crucible and melted at 700°C to 1,000°C in the air for 1 hour to 2 hours. The molten glass was then formed into a film shape with a water-cooled roller. The film-shaped glass was ground with a ball mill and then passed through a sieve with an opening of 75 µm, and a glass powder with an average particle size D₅₀ of about 10 µm was obtained.

The obtained glass powder was then mixed with a refractory filler powder as shown in the tables, and a mixed powder was obtained.

As the refractory filler powder, substantially spherical Zr₂WO₄(PO₄)₂ (denoted as ZWP in the tables) was used. The average particle size D₅₀ of the refractory filler powder was about 10 µm.

Samples Nos. 1 to 27 were evaluated for the glass transition point, the thermal expansion coefficient, the softening point, the fluidity, and the weather resistance.

The glass transition point and the thermal expansion coefficient at a temperature range of 30°C to 150°C were evaluated as follows. First, the mixed powder was placed in a bar-shaped mold, press-molded, and then fired at 280°C to 350°C for 10 minutes on an alumina substrate coated with a release agent. Thereafter, the fired body was processed into a predetermined shape and measured with a TMA apparatus.

The softening point was measured with a macro-type differential thermal analyzer, and the fourth inflection point was taken as the softening point. A measurement atmosphere was in the air, a heating rate was 10°C/min, and the measurement was started from room temperature.

The fluidity was evaluated as follows. A mass corresponding to a combined density of the mixed powder was placed in a mold with a diameter of 20 mm and press-molded. Thereafter, Samples Nos. 1 to 12 and 17 to 27 were fired on a glass substrate at 350°C for 10 minutes. Samples Nos. 13 to 16 were fired on a glass substrate at 300°C for 10 minutes. A fired body having a flow diameter of 19 mm or more was rated as "good", and a fired body having a flow diameter of less than 19 mm was rated as "poor".

The weather resistance was evaluated by an accelerated degradation test according to a pressure cooker test (PCT). Specifically, the fired body produced above was held in an environment at 121°C, 2 atm, and a relative humidity of 100% for 24 hours and then visually observed. A fired body with no precipitate from the surface was rated as "good" and otherwise as "poor".

As is clear from the tables, the fluidity and the weather resistance of Samples Nos. 1 to 9 and 13 to 27 were evaluated as good. On the other hand, Sample No. 10 contained a small amount of V₂O₅ in the glass composition, and CuO was not contained, and thus the softening point was high and the fluidity was poor. Sample No. 11 contained a small amount of V₂O₅ in the glass composition, and thus the softening point was high and the fluidity was poor. Sample No. 12 contained a large amount of V₂O₅ in the glass composition, and thus the glass was devitrified during firing.

### INDUSTRIAL APPLICABILITY

The glass composition according to the present invention is suitable for sealing a crystal oscillator package and in addition, suitable for sealing an airtight package, such as those of a semiconductor integrated circuit, a flat display device, a glass terminal for an LED, and an aluminum nitride substrate. In addition, the glass composition can also be used as a sealing material for a metal and vacuum insulation glass.

## Claims

1. Aglass composition comprising: in mol%, 15% to 80% of TeO₂, 0.1% to 30% of MoO₃ + Ag₂O, 5% to 40% of V₂O₅, 0.1% to 35% of CuO, and 0% to 10% ofPbO as glass composition.

2. The glass composition according to claim 1, comprising: in mol%, 0.3% to 25% of CuO, 1% to 30% of Li₂O + Na₂O + K₂O, and 1% to 30% of MgO + CaO + SrO + BaO + ZnO as glass composition, and substantially free of SeO₂.

3. The glass composition according to claim 1 or 2, wherein a content of ZnO is 0 mol% to 25 mol%.

4. The glass composition according to any of claims 1 to 3, wherein a content of Nb₂O₅ is 0 mol% to 10 mol%.

5. The glass composition according to any of claims 1 to 4, comprising: in mol%, 0% to 10% of Fe₂O₃, 0% to 10% of Al₂O₃, 0% to 20% of B₂O₃, and 0% to 20% of WO₃ as glass composition.

6. A sealing material comprising: 40 vol% to 100 vol% of a glass powder made of the glass composition according to any of claims 1 to 5; and 0 vol% to 60 vol% of a refractory filler powder.

7. The sealing material according to claim 6, wherein the refractory filler powder is substantially spherical.

8. The sealing material according to claim 6 or 7, wherein the refractory filler powder is entirely or partially Zr₂WO₄(PO₄)₂.

9. The sealing material according to any of claims 6 to 8 for use in a crystal oscillator package.

10. The sealing material according to any of claims 6 to 8 for use in vacuum insulation glass.

11. A sealing material paste comprising: the sealing material according to any of claims 6 to 10; and a vehicle.
